# EUROPÄISCHE PATENTSCHRIFT

(11) **EP 1 247 107 B1**
(45) Veröffentlichungstag und Bekanntmachung des Hinweises auf die Patenterteilung: **08.10.2003**
(21) Anmeldenummer: 00991108.2
(22) Anmeldetag: 20.12.2000
(51) Int. Cl.: G01R 1/04, G01R 31/316

(54) **TESTVORRICHTUNG FÜR EIN HALBLEITERBAUELEMENT**
TEST DEVICE FOR A SEMICONDUCTOR COMPONENT
DISPOSITIF POUR TESTER UN COMPOSANT A SEMICONDUCTEURS

(30) Priorität: 13.01.2000 DE 10001117
(43) Veröffentlichungstag der Anmeldung: 09.10.2002
(73) Patentinhaber: Infineon Technologies AG, 81669 München (DE)
(72) Erfinder: SCHWEIGER, Dieter, 93138 Lappersdorf (DE); WÜRZINGER, Mathias, 94160 Ringelai (DE)
(74) Vertreter: Epping Hermann & Fischer
(86) Internationale Anmeldenummer: DE0004564
(87) Internationale Veröffentlichungsnummer: WO01051935

(56) Entgegenhaltungen:
- EP-A- 0 646 800
- WO-A-96/14660
- WO-A-99/32895
- US-A- 4 980 638
- US-A- 5 180 974
- US-A- 5 528 466
- HOCK T K ET AL: "RADIO FREQUENCY TEST CONNECTOR" MOTOROLA TECHNICAL DEVELOPMENTS,MOTOROLA INC. SCHAUMBURG, ILLINOIS,US, Bd. 10, 1. März 1990 (1990-03-01), Seiten 108-112, XP000114675

## Beschreibung

Die Erfindung betrifft eine Testvorrichtung für ein Halbleiterbauelement, das mindestens einen ersten Kontakt aufweist, mit mindestens einem zweiten Kontakt zum Herstellen einer elektrischen Verbindung zu dem ersten Kontakt.

Testvorrichtungen dienen dazu, Halbleiterbauelemente nach ihrer Fertigung auf ihre Funktionstüchtigkeit zu überprüfen. Das Halbleiterbauelement, der Prüfling, der erste Kontakte aufweist, wird dabei auf die Testvorrichtung aufgebracht, wobei die ersten Kontakte mit zweiten Kontakten der Testvorrichtung in Verbindung stehen, um eine elektrische Verbindung herzustellen. Einige der zweiten Kontakte werden mit vorgegebenen Potentialen beaufschlagt. An anderen zweiten Kontakten werden dann die von dem Halbleiterbauelement gelieferten Signale abgegriffen und einer Auswertung zugeführt.

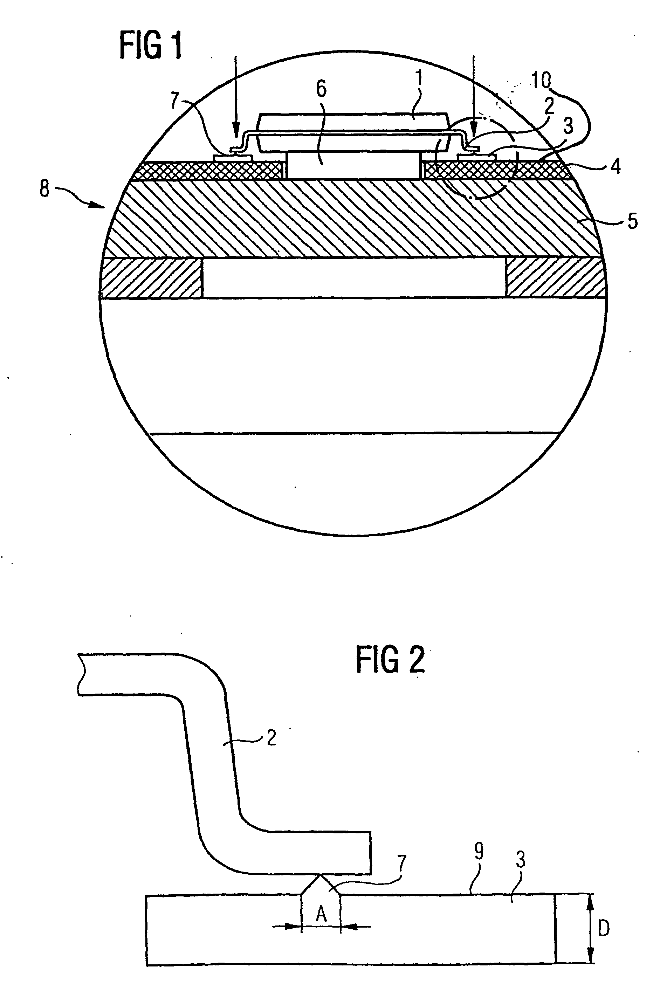

Die Ausgestaltung der zweiten Kontakte der Testvorrichtung ist beispielsweise in dem Artikel von B. J. Thompson, "Get grip on RF components", aus Test und Measurement World, May 1994, Seite 73 ff. beschrieben. In der Figur 1 dieses Artikels ist ein Ausschnitt einer üblicherweise verwendeten Testvorrichtung dargestellt. Die zweiten Kontakte, das heißt die Kontakte der Testvorrichtung, sind drehbar um eine horizontale Elastomerachse mit der Testvorrichtung verbunden. Das Halbleiterbauelement wird so auf die Testvorrichtung aufgebracht, daß die ersten Kontakte (des Halbleiterbauelementes) mit den zweiten Kontakten (der Testvorrichtung) in Verbindung kommen. Um eine niederohmige Verbindung zwischen dem ersten und dem zweiten Kontakt herzustellen, übt ein Stempel (Contact pressure block) Druck auf den ersten Kontakt aus. Durch den Stempeldruck werden die beweglich gelagerten zweiten Kontakte der Testvorrichtung aus ihrer Ruhestellung leicht verdreht.

Durch die geringe Relativbewegung des zweiten Kontaktes zu dem ersten Kontakt findet im Laufe der Zeit eine Abnutzung der zweiten Kontakte statt. Hierdurch rauht sich die Oberfläche der zweiten Kontakte auf. Der Übergangswiderstand zwischen dem ersten und dem zweiten Kontakt verändert sich somit im Laufe der Zeit. Der sich im Laufe der Zeit variierende Übergangswiderstand kann somit die Testergebnisse verfälschen.

Ein weiterer Nachteil der federnd gelagerten zweiten Kontakte besteht darin, daß sich mit variierendem Abstand die Kapazität zwischen dem ersten Kontakt und der Leiterbahn (Signal trace) verändert. Eine derartige Variation der parasitären Kapazitäten kann ebenfalls zu einer Verfälschung der Meßergebnisse führen.

Das Dokument WO 99/328 95 beschreibt eine Testvorrichtung mit den Merkmalen des Oberbegriffes des Anspruches 1.

Die Aufgabe der vorliegenden Erfindung besteht deshalb darin, eine Testvorrichtung für ein Halbleiterbauelement bereit zu stellen, das die oben genannten Nachteile nicht aufweist.

Diese Aufgabe wird mit den Merkmalen des Patentanspruches 1 gelöst.

Vorteilhafte Ausgestaltungen ergeben sich aus den Unteransprüchen.

Vorzugsweise werden die Abmaße des Plättchens so gewählt, daß sie größer als die ersten Kontakte des Halbleiterbauelementes sind. Hierdurch wird ein sicherer Kontakt ermöglicht. Andererseits läßt sich das Plättchen aufgrund seiner ebenen Hauptseite gut mit einem Leiterzug der Testvorrichtung verbinden. Die Verbindung zwischen dem Plättchen und dem Leiterzug kann beispielsweise durch Löten vorgenommen werden.

Vorzugsweise bestehen die zweiten Kontakte aus einem harten, gut leitendem Material. Je härter das Material ist, desto weniger Abnutzung macht sich im Laufe der Zeit bemerkbar. In einer bevorzugten Variante bestehen die zweiten Kontakte aus Beryllium-Kupfer. Es wäre auch denkbar, die zweiten Kontakte aus Platin herzustellen. Beryllium-Kupfer weist die Eigenschaft auf, daß es nur eine geringe mechanische Ausdehnung bei schwankenden Temperaturen aufweist. Durch die geringe Ausdehnung ergeben sich sehr kleine parasitäre elektrische Komponenten, die die Eigenschaften des Halbleiterbauelementes während des Testvorganges praktisch nicht beeinflussen. Die kleinen parasitären elektrischen Komponenten können die oben bereits erwähnte Parallelkapazität oder eine Serieninduktivität darstellen.

Um einen möglichst geringen Kontaktierwiderstand und eine Unempfindlichkeit gegenüber Ablagerungen beziehungsweise Verschmutzungen zu erzielen, ist es vorteilhaft, die Oberfläche der zweiten Kontakte derart auszugestalten, daß diese Spitzen aufweisen. Die Spitzen können dabei in Form eines Dreieckes, eines Vieleckes oder einer anderen beliebigen Form gebildet sein. Dabei sollte der Abstand der Spitze der Oberfläche des zweiten Kontaktes nach Möglichkeit nicht höher als die Breite der Spitze auf der Oberfläche der zweiten Kontakte sein. Auch bei hohen mechanischen Belastungen ist dann sichergestellt, daß die Spitze nicht brechen kann. Die Spitze ist auf der Oberfläche des zweiten Kontaktes angeordnet, die dem ersten Kontakt des Halbleiterbauelementes zugewandt ist. Zum Testen werden die ersten Kontakte des Halbleiterbauelementes dann über einen Stempel auf die Spitzen der zweiten Kontakte jeweils separat aufgedrückt. Es versteht sich von alleine, daß der druckausübende Stempel aus einem isolierenden Material besteht.

Sollten während des Testens hohe Temperaturen in dem Halbleiterbauelement entstehen, so kann es vorteilhaft sein, in der Testvorrichtung eine Wärmesenke vorzusehen, die dann mit dem Halbleiterbauelement in Verbindung steht.

Die Erfindung wird anhand der nachfolgenden Figuren näher erläutert. Es zeigen:
- Figur 1: ein Ausführungsbeispiel der Erfindung im Querschnitt und
- Figur 2: einen Ausschnitt aus Figur 1, der einen ersten und einen zweiten Kontakt vergrößert darstellt.

Figur 1 zeigt ein Ausführungsbeispiel der erfindungsgemäßen Testvorrichtung 8. Die Testvorrichtung 8 weist ein isolierendes Substrat 4 auf, auf dem Leiterzüge 10 aufgebracht sind. Das Substrat 4 ist seinerseits auf einem Träger 5 gelegen, der über eine Wärmesenke 6 mit einem Halbleiterbauelement 1 verbunden, einen massebezogenen, gut wärmeleitenden Kontakt zu dem Halbleiterbauelement 1 herstellt. Jeder Leiterzug 10 ist mit einem zweiten Kontakt 3 verbunden. Der zweite Kontakt 3 ist in Form eines Plättchens, vorzugsweise aus Beryllium-Kupfer, ausgeführt. Der zweite Kontakt 3 ist dabei zum Beispiel durch Löten mit dem Leiterzug 10 fest verbunden.

Der zweite Kontakt 3 weist eine Spitze 7 auf, die mit einem ersten Kontakt 2 eines Halbleiterbauelementes verbunden ist. Die ersten Kontakte 2 werden dabei durch einen Druck auf die zweiten Kontakte 3 aufgepreßt. Dieser Sachverhalt soll lediglich durch die Pfeile dargestellt sein. Das druckausübende Werkzeug ist in der Figur 1 nicht dargestellt. Das druckausübende Werkzeug sorgt dafür, daß sich die Spitzen 7 der zweiten Kontakte 3 in die ersten Kontakte 2 leicht eindrücken. Hierdurch kann ein geringer Übergangswiderstand hergestellt werden.

In der Figur 2 ist die mechanische Verbindung zwischen dem ersten Kontakt 2 und dem zweiten Kontakt 3 mit seiner Spitze 7 vergrößert dargestellt. Der zweite Kontakt 2 liegt dabei auf der Spitze 7 auf. Durch das druckausübende Werkzeug (nicht dargestellt) drückt sich die Spitze 7 leicht in den ersten Kontakt 2 ein.

Die Spitze 7 ist in dem vorliegenden Ausführungsbeispiel in Form eines Dreiecks ausgebildet. Die Spitze 7 könnte selbstverständlich auch in Form eines Vieleckes oder einer beliebigen anderen Form ausgeführt sein. Es ist vorteilhaft, wenn der Abstand zwischen der Spitze 7 und der Oberfläche 9 eines zweiten Kontaktes 3 geringer ist als der Abstand A. Die Spitze 7 kann beispielsweise dadurch hergestellt werden, daß das im Querschnitt quaderförmige Plättchen von der Oberfläche 9 her abgefräst wird. Der zweite Kontakt 3 weist dabei vorzugsweise eine Dicke D von 200 bis 300 µm auf. Hierdurch wird eine hohe Haltbarkeit des zweiten Kontaktes gewährleistet.

In der Figur 1 ist ein Halbleiterbauelement 1 dargestellt, bei dem die ersten Kontakte 2 seitlich seines Gehäuses liegen. Es wäre jedoch auch denkbar, die erfindungsgemäße Testvorrichtung bei Halbleiterbauelementen anzuwenden, bei denen die ersten Kontakte unterhalb des Gehäuses zum liegen kommen. Es versteht sich von selbst, daß die zweiten Kontakte 3 jeweils an das Layout der ersten Kontakte 2 des Halbleiterbauelementes angepaßt werden müssen. Bei Halbleiterbauelementen, bei denen die ersten Kontakte unterhalb des Gehäuses zum Liegen kommen, müßte ein Werkzeug den Druck dann direkt auf das Gehäuse ausüben, um eine niederohmige Verbindung zwischen den ersten und den zweiten Kontakten herzustellen.

Im Vergleich zu Testvorrichtungen aus dem Stand der Technik, die auf federnde Kontakte zurückgreifen, treten bei der erfindungsgemäßen Testanordnung aufgrund der bezüglich zur Testvorrichtung unbeweglichen zweiten Kontakte wesentlich geringere parasitäre elektrische Komponenten auf. Da kaum mechanische Belastungen auf die zweiten Kontakte wirken, ist eine lange Haltbarkeit der zweiten Kontakte der Testvorrichtung gewährleistet.

### Bezugszeichenliste

- 1: Halbleiterbauelement
- 2: Erster Kontakt
- 3: Zweiter Kontakt
- 4: Substrat
- 5: Träger
- 6: Wärmesenke
- 7: Spitze
- 8: Vorrichtung
- 9: Oberfläche
- 10: Leiterzug

## Patentansprüche

1. Testvorrichtung für ein Halbleiterbauelement (1), das mindestens einen ersten Kontakt (2) aufweist, mit mindestens einem zweiten Kontakt (3) zum Herstellen einer elektrischen Verbindung zu dem ersten Kontakt (2), wobei der zweite Kontakt (3) bezüglich der restlichen Testvorrichtung (8) unbeweglich ist,
**dadurch gekennzeichnet,**
**dass** der mindestens eine zweite Kontakt (3) in Form eines auf einem der Testrorrichtung zugehörigen Leiterzug (10) aufgebrachten Plättchens ausgebildet ist.

2. Testvorrichtung nach Anspruch 1
**dadurch gekennzeichnet,**
**dass** die zweiten Kontakte (3) aus einem harten, gut leitenden Material bestehen.

3. Testvorrichtung nach Anspruch 1 oder 2
**dadurch gekennzeichnet,**
**dass** die zweiten Kontakte (3) aus Beryllium-Kupfer bestehen.

4. Testvorrichtung nach einem der Ansprüche 1 bis 3
**dadurch gekennzeichnet,**
**dass** die zweiten Kontakte (3) Spitzen (7) aufweisen.

## Claims

1. Test device for a semiconductor component (1) which has at least one first contact (2), with at least one second contact (3) for establishing an electrical connection with the first contact (2), the second contact (3) being immovable with respect to the rest of the test device (8), **characterized in that** the at least one second contact (3) takes the form of a platelet applied to a conductor trace (10) associated with the test device.

2. Test device according to Claim 1, **characterized in that** the second contacts (3) consist of a hard material with good conducting properties.

3. Test device according to Claim 1 or 2, **characterized in that** the second contacts (3) consist of beryllium copper.

4. Test device according to one of Claims 1 to 3, **characterized in that** the second contacts (3) have peaks (7).

## Revendications

1. Dispositif pour tester un composant (1) à semi-conducteur, qui a au moins un premier contact (2), comprenant au moins un deuxième contact (3) pour ménager une liaison électrique avec le premier contact (2), le deuxième contact (3) étant immobile par rapport au reste du dispositif (8) de test,
**caractérisé**
**en ce que** le au moins un deuxième contact (3) est constitué sous la forme d'une plaquette déposée sur une piste (10) conductrice faisant partie du dispositif de test.

2. Dispositif de test suivant la revendication 1,
**caractérisé**
**en ce que** les deuxièmes contacts (3) sont en une matière dure et bonne conductrice.

3. Dispositif de test suivant la revendication 1 ou 2,
**caractérisé**
**en ce que** les deuxièmes contacts (3) sont en en béryllium-cuivre.

4. Dispositif de test suivant l'une des revendications 1 à 3,
**caractérisé**
**en ce que** les deuxièmes contacts (3) ont des pointes (7).
